(19) **Europäisches Patentamt**

**European Patent Office**

**Office européen des brevets**

(11) Publication number: **0 145 335 B1**

# (12) EUROPEAN PATENT SPECIFICATION

(45) Date of publication of patent specification: **27.03.91**  (51) Int. Cl.⁵: **H03M 1/76**

(21) Application number: **84307955.9**

(22) Date of filing: **16.11.84**

(54) Digital-to-analog converter.

(30) Priority: **18.11.83 US 553041**

(43) Date of publication of application:
**19.06.85 Bulletin 85/25**

(45) Publication of the grant of the patent:
**27.03.91 Bulletin 91/13**

(84) Designated Contracting States:
**CH DE FR GB IT LI SE**

(56) References cited:
**EP-A- 0 074 860**
**EP-A- 0 095 674**
**GB-A- 2 069 265**

**PATENT ABSTRACTS OF JAPAN, vol. 7, no. 154 (E-185)[1299], 6th July 1983 & JP-A-58-63 227**

**IEEE JOURNAL OF SOLID-STATE CIRCUITS, vol. SC-16, no. 3, June 1981, pages 155-163, IEEE, New York, US; M. COOPERMAN et al.: "Charge redistribution Codec"**

(73) Proprietor: **BROOKTREE CORPORATION**
**11175 Flintkote Avenue - Suite F**
**San Diego California 92121(US)**

(72) Inventor: **Katzenstein, Henry S.**
**739 Brooktreet Road**
**Pacific Palisades California 90272(US)**

(74) Representative: **Pears, David Ashley et al**
**REDDIE & GROSE 16 Theobalds Road**
**London WC1X 8PL(GB)**

## Description

This invention relates to apparatus for converting data between a digital form and an analog form. More particularly, the invention relates to apparatus which provides such conversion instantaneously and on a monotonic basis and in a simple and reliable manner. The converter of this invention is particularly adapted to be disposed on an integrated circuit chip so that an optimal number of digits can be converted from a digital value to an analog value on a chip of minimal size.

Various types of equipment receive information in analog form. Such equipment includes process control equipment, measuring instruments, communication equipment and a wide variety of other equipment. Digital computers and data processing systems often receive input parameters in analog form from such equipment and convert these parameters to digital form for processing in the computer or the data processing equipment. after the analog information has been converted to digital information and has been processed, the output information from the digital computer or the data processing equipment is often converted to analog form. By converting the digital information to analog form, the user can assimilate the information in ways which would be difficult if the information remained in digital form.

A good example of the conversions discussed in the previous paragraph is in the recording and reproduction of music. The music is produced in analog form. It is converted to digital form by recently developed data processing techniques and is recorded on a medium such as a tape or a disc. When the music is to be reproduced, it is converted again to analog form because this is the form which is necessary to operate sound transducers to give meaning to the listener when he hears the music.

As digital computers and data processing equipment have become widespread throughout industry and the office and have even become common in the home, the need for inexpensive, simple and reliable apparatus for converting information between analog and digital forms has become of increasing concern. A considerable effort has been devoted over a period of several decades to provide for converting apparatus which is simple, inexpensive and reliable. In spite of such efforts, the converting apparatus now in use does not meet such criteria.

The converting apparatus now in use also has other problems of long-standing. For example, the converting apparatus now in use may not be monotonic unless it is quite expensive and complex. By "monotonic" is meant that digital information of progressively increasing value is converted to analog information of progressively increasing value without any decrease in the analog value as the digital value progressively increases. The converting apparatus now in use also has relatively high differential and integral non-linearities unless the apparatus is quite expensive and complex. Integral non-linearities result from errors produced in a conversion between analog and digital values over a wide range of such values. Differential non-linearities result from errors produced in a conversion between analog and digital values over a relatively narrow range of such values.

The converting apparatus now in general use also has a problem of major proportions. This results when particular digital values are increased incrementally by a single digit. For example, problems in the converters now in use result when a binary representation of "511" is converted to a binary representation of "512". This results from the fact that the binary representation of "511" is represented by a value of 0111111111 and a binary representation of "512" is represented by 1000000000 where the least significant digit is at the right. As will be seen, the value of each binary digit changes when the decimal value changes from "511" to "512". As the binary values change from 0111111111 to 1000000000, discontinuities may occur because there is a change between a binary value of "0" and a binary value of "1" at each digital position. These discontinuities may prevent the converter from being truly monotonic. This problem even exists in converters which are made quite complex in an attempt to overcome the problem.

Apparatus for converting between analog and digital values on a monotonic basis is disclosed in our published European Patent Application EP 0 095 674 which forms part of the state of the art only by virtue of Article 54(3)EPC. Such apparatus is simple and inexpensive and reliable. It is able to operate with a high precision at high levels of power. As a result, the converting apparatus is capable of being used in areas not available for the converters of the prior art. For example, such apparatus is able to convert oral information in analog form into information in digital form and to convert the digital information back to the oral information in analog form by serving both as a converter and a amplifier.

The apparatus disclosed and claimed in application EP 0 095 674 also has other advantages of some importance. For example, it provides analog values of progressively increasing value as the digital value to be converted increases. It provides low differential and integral non-linearities. It is also free of the effects of aging and changes in temperature. It also provides accurate and reliable conversions between analog and digital values at high frequencies with minimal error. The converter is also able to provide an instantaneous conversion between analog and digital values and to provide a monotonic operation even while providing minimal integral and differential non-linearities. The converter is also quite simple in construction and is reliable in operation.

In the converter disclosed and claimed in application EP 0 095 674 apparatus is provided for converting between analog and digital values. The apparatus includes means for providing a plurality of signals representing the digital values. Sub-sets of control switches are also provided, the number of control switches in each sub-set being directly related to the digital significance of the control switches in such sub-set. The control switches in each sub-set may be paired to provide for a conductivity of one switch in each pair. The signals representing individual digital values are introduced to the associated sub-sets to provide for the conductivity of an individual one of the control switches in each pair in accordance with the digital value represented by such signals.

A plurality of output members are also provided in the converter disclosed and claimed in application EP 0 095 674. The output members are preferably transistors. The control switches are connected to the output members in a recursive relationship defined by repetitions of a basic block. Each basic block is in turn defined by a pair of basic sub-blocks. The sub-sets of control switches are connected in the recursive relationship to define a particular matrix for providing paths through the conductive ones of the control switches. Since the output members are conductive, the control switches operate to introduce the current through the output members to one of two output lines. For progressive increases in the digital value, a progressive number of the output members are connected to a particular one of the output lines, and output members previously connected to the particular output line are maintained connected to the output line with such progressive increases in the digital value. The cumulative current through the output members connected to the particular output line is indicative of the analog value.

Essentially the converter of EP 0 095 674 comprises a tree of switches arranged in a succession level with the switches at each level controlled by a digital signal on a corresponding input line, a current source connected to the highest level switches and connections between the switches and an output line such that an output current is provided in the output line of magnitude corresponding to the combination of digital signals applied to the input lines.

When the converter of application EP 0 095 674 is to be used to convert audio information in digital form to audio information in analog form, at least fourteen (14), and preferably sixteen (16), bits of information generally have to be provided. Furthermore, it is preferred that this information be provided on an integrated circuit chip having a relatively small size. Before the provision of the converters of this invention, it has been difficult, if not impossible, to provide a converter with the features described in this paragraph.

This invention provides an improvement in the converter of application EP 0 095 674 to meet the objectives discussed in the previous paragraph. The improved converter of this invention includes control switches connected in the same recursive relationship as in the converter of application EP 0 095 674 to define a matrix. However, capacitors take the place of output members in the converter of this invention, which is defined in claim 1 below.

By using capacitors as current sources, the response time of the converter is considerably slowed in comparison to the converter of application EP 0 095 674 This does not constitute a disadvantage when the converter of this invention is used in audio applications since the response time of the converter of this application is still considerably faster than the sampling interval which is produced when the audio information is sampled at a rate of approximately forty-four (44) kilocycles per second.

Capacitors are also advantageous compared with the transistor output members because they can be easily formed on an integrated circuit chip and can be duplicated so that there are minimal errors in value between the different capacitors on the chip. For example, the capacitors can be provided on the chip with deviations in value as low as one tenth of one percent (0.1%). This is even true when the capacitors are disposed at the extremities of the chip. The use of capacitors is also advantageous since any need for additional stages such as operational or reference amplifiers is eliminated.

The use of capacitors also provides other important advantages. For example, the capacitors are stable from a temperature standpoint. Furthermore, if there are any changes in temperature, all of the capacitors are affected substantially the same so that there is no change in the overall operation of the converter. The capacitors are also advantageous in the sense that there is no, if very little, energy loss in the capacitors.

In the drawings:

Figure 1 is a schematic circuit diagram of one embodiment of the invention, this embodiment including capacitors as current sources and this embodiment having preferable application to digital audio systems;

Figure 2 is a truth table illustrating the operation of the system shown in Figure 1:

Figure 3 is a block diagram of another embodiment of the invention, this embodiment illustrating the interconnection of more than one of the embodiments shown in Figure 1;

Figure 4 is a simplified circuit diagram illustrating another transistor arrangement which can be used in the embodiment of Figure 1;

Figure 5 is a block diagram of another embodiment of the invention, this embodiment constituting an improvement of the embodiment shown in Figure 3;

Figure 6 is a schematic diagram of an integrated circuit chip on which the converter shown in Figure 1 may be disposed;

Figure 7 is a schematic diagram of an integrated circuit chip on which a plurality of converters such as shown in Figure 1 may be disposed in modular form;

Figure 8 is a schematic diagram showing the spaced disposition on an integrated circuit chip of different transistors shown in Figure 1;

Figure 9 is a schematic diagram illustrating the construction on the integrated circuit chip of the capacitors which are used as the current sources;

Figure 10 is a schematic diagram illustrating the construction of capacitors of different values on the integrated circuit chip; and

Figure 11 is a block diagram showing an analog-to-digital converter which incorporates the apparatus of Figure 1.

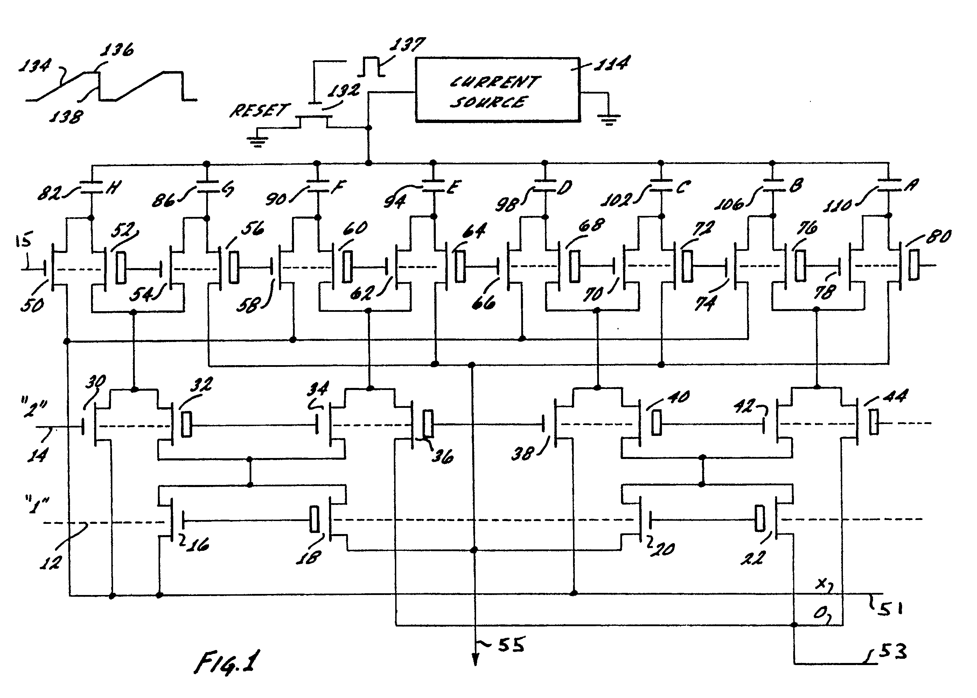

In the embodiment of the invention shown in Figure 1, a digital-to-analog converter generally indicated at 10 is provided. The converter 10 receives digital signals on a plurality of input lines 12, 14 and 15. The signals on the lines preferably represent information in binary form. For example, the signals on the line 12 may represent a binary value of "1" and the signal on the lines 14 and 15 may respectively represent binary values of "$2^1$" and "$2^2$". Illustratively, a binary "1" may be represented by a signal of high amplitude and a binary "0" may be represented by a signal of low amplitude. Although only three (3) digits are shown, it will be appreciated that any particular number of digits may be used.

In the embodiment shown in Figure 1, the line 12 is connected to the gates of transistors 16, 18, 20 and 22. The transistors 16, 18, 20 and 22 may constitute field effect transistors, particularly MOS field effect transistors, or may constitute any other suitable type of control transistor. The transistors 16 and 20 may particularly comprise N-channel field effect transistors and the transistors 18 and 22 may comprise P-channel field effect transistors.

Similarly, the line 14 is connected to the gates of transistors 30, 32, 34, 36, 38, 40, 42 and 44. As with the transistors 16, 18, 20 and 22, the transistors 30 through 44 (even numbers only) may constitute field effect transistors or any other suitable type of transistor. when field effect transistors are used, the transistors 30, 34, 38 and 42 may constitute N-channel field effect transistors and the transistors 32, 36, 40 and 44 may constitute P-channel effect transistors.

The sources of the N-channel transistors 16, 30 and 38 are conneoted to an output line 51 and the sources of the P-channel transistors 22, 36 and 44 are connected to an output line 53. A connection is made from the source of the P-channel field effect transistor 18 and the source of the N-channel field effect transistor 20 to an interpolation line 55. The drains of the transistors 16 and 18 are common with the sources of the transistors 32 and 34. Similarly, the drains of the transistors 20 and 22 and the sources of the transistors 40 and 42 have a common terminal.

Gates of transistors 50, 52, 54, 56, 58, 60, 62, 64, 66, 68, 70, 72, 74, 76, 78 and 80 receive the signals on the line 15. Connections are respectively made from the drains of the transistors 30 and 32, the transistors 34 and 36, the transistors 38 and 40 and the transistors 42 and 44 to the sources of the transistors 52 and 54, the transistors 60 and 62, the transistors 68 and 70 and the transistors 76 and 78. The transistors 50, 54, 58, 62, 66, 70, 74 and 78 may be N-channel field effect transistors and the transistors 52, 56, 60, 64, 68, 72, 76 and 80 may be P-channel field effect transistors.

The drains of the transistors 50 and 52, the transistors 54 and 56, the transistors 58 and 60, the transistors 62 and 64, the transistors 66 and 68, the transistors 70 and 72, the transistors 74 and 76 and the transistors 78 and 80 may be respectively connected to first plates of capacitors 82, 86, 90, 94, 98, 102, 106 and 110. Second plates of the capacitors are connected to a current source 114, which is preferably constructed to provide a constant current.

The capacitors 82, 86, 90, 94, 98, 102, 106 and 110 may be provided with substantially equal and relatively low values. For example, the capacitors may be provided with values in the order of five (5) picofarads.

The sources of the transistors 50, 58, 66 and 74 have a common connection with the first output line 51 and the sources of the transistors 56, 64, 72 and 80 have a common connection with the output line53.

The N-channel field effect transistors such as the transistor 16 are non-conductive when a signal having a relatively low voltage and representing a digital value of "0" is introduced to the bases of the transistors. The N-channel field effect transistors such as the transistor 16 become conductive when a positive voltage representing a digital value of "1" is introduced to the bases of the transistors.

In contrast, the P-channel field effect transistors such as the transistor 18 are non-conductive when a positive voltage is introduced to the base of the transistor in representation of a digital value of "1". The P-channel field effect transistors become conductive when a negative voltage representing a digital value of "0" is introduced to the bases of the transistors.

The transistors shown in Figure 1 may be considered as being paired. For example, the transistors 16 and 18 in Figure 1 may be considered as being paired. Only one of these transistors is conductive at any instant and the other transistor is non-conductive at that instant. Similarly, the transistors 30 and 32 and the transistors 50 and 52 may be considered as paired.

The switches 16, 18, 20 and 22 may be considered as one sub-set; the switches 30 through 44 (even numbers only) may be considered as a second sub-set; and the switches 50 through 80 (even numbers only) may be considered as a third sub-set. All of the switches may be considered to constitute a plurality. The matrix relationship defined by these control switches may be considered to be disposed in the form of a pyramid since the number of switches in each sub-set increases for the digits of progressively increasing significance.

The control switches are connected in a recursive relationship. This results from the fact that the switches are connected in repetitions of a basic block. This block may be considered to constitute the switches 16 and 18 and the switches 30, 32, 34 and 36. The recursive relationship defined by these switches may be considered as being divided into two (2) recursive sub-blocks, one (1) recursive sub-block being provided by the switches 16, 30 and 32 and the other being provided by the switches 18, 34 and 36. The control switches may be considered as being connected in a recursive relationship because the matrix relationship defined by the control switches may be considered to be formed from repetitions of the blocks and sub-blocks.

As will be seen, the control switches 16, 18, 20, 22, the control switches 30 through 44 (even numbers only) and the control switches 50 through 80 (even numbers only) may be connected in the matrix relationship to one another and to the capacitors 82, 86, 90, 94, 98, 102, 106 and 110 to minimize any cross-over of leads connecting the control switches and the capacitors. This is important in minimizing stray capacitive effects in the matrix relationship. Such stray capacitive effects are undesirable since they would otherwise tend to limit the maximum frequency at which the system of Figure 1 can operate and since they are not entirely predictable.

The operation of the circuit of Figure 1 may be seen from specific examples. For example, for an analog value of "1" represented by a digital "1" on the line 12 and a digital "0" on the lines 14 and 15, the transistors 16 and 20 become conductive and the transistors 32, 36, 40 and 44 and the transistors 52, 56, 60, 64, 68, 72, 76 and 80 are conductive. This causes a capacitive-discharge current to flow through a circuit including the current source 114, the capacitor 82 the control transistor 52, the control transistor 32 and the transistor 16 to the output line 51 to indicate an analog value of "1". At the same time, a capacitive-discharge current flows through a circuit including the current source 114, the capacitor 98, the transistor 68, the transistor 40, the transistor 20 and the interpolation line 54. The capacitive-discharge currents through all of the other capacitors are introduced to the line 53. Since only the capacitive-discharge current in the line 51 is effective in indicating the analog value represented by the digital signals, an analog value of "1" is indicated by the current on the line 51. The currents are designated as "capacitive-discharge" since the discharge of capacitances such as in the circuits described above for the digital value of "1" may be considered to provide currents.

The transistors 30, 34, 38 and 42, the transistors 18 and 22 and the transistors 52, 56, 60, 64, 68, 72, 76 and 80 become conductive for an analog value of "2". When this occurs, the capacitor 82 passes a capacitive-discharge current to the line 51 through the transistors 52 and 30 and the capacitor 98 passes a capacitive-discharge current to the line 51 through the transistors 68 and 38. The capacitor 90 passes a capacitive-discharge current to the interpolation line 55 through a circuit including the current source 114, the capacitor 90, the transistors 60 and 34, the transistor 18 and the interpolation line. All of the other capacitors pass a capacitive-discharge current to the line 53. In this way, the output line 51 receives a capacitive-discharge current from two (2) of the output members, corresponding to the analog value of "2".

Figure 1 also includes a gating switch which may constitute a field effect transistor 132. One terminal, such as the source, of the transistor may be connected to a reference voltage such as ground. A second terminal, such as the gate, of the transistor 132 may receive a periodic signal. For example, when audio information is being converted, the gating signal may be provided at a sampling rate such as approximately forty-four kiloherz (44 Khz). A third electrode, such as the drain, of the transistor 132 may be connected to the current source 114 and the capacitor 82, 96, 90, 94, 98, 102, 106 and 110.

The transistor 132 is normally non-conductive. During the time that the transistor 132 is non-conductive, the digital signals on the lines 12, 14 and 15 in Figure 1 produce a pattern of operation in the matrix arrangement in Figure 1 so that the capacitors 82, 86, 90, 94, 98, 102, 106 and 110 become charged. This is illustrated at 134 in Figure 1. The capacitors become fully charged in a relatively short period of time because of their relatively low value. The completion of such charging is illustrated at 136 in Figure 1.

When the gating signal, such as that shown at 137, is periodically introduced to the gate of the transistor 132, it causes the transistor to become conductive and a low impedance to be produced between the drain and the source of the transistor so that the drain and the source of the transistor are effectively grounded. This causes the capacitors 82, 86, 90, 94, 98, 102, 106 and 110 to be discharged through the output lines 51 and 53. This discharge is instantaneous because of the low impedance in the discharging circuit. The discharge or the capacitors is illustrated at 138 in Figure 1. The capacitive-discharge current through the output line 51 has a value directly representative of the number of the capacitors connected to the line. The amplitude of this discharge represents in analog form the digital value of the signals introduced to the lines 12, 14 and 15.

The current flowing through each of the capacitors 82, 86, 90, 94, 98, 102, 106 and 110 has a relatively low value. For example, when the voltage from the source 114 has a value such as five volts (5v) and each of the capacitors has a value of approximately five picofarads (5pf), the current through each capacitor may have a value such as a few microamperes. For example, the current through each of the capacitors may be approximately five microamperes (5ua).

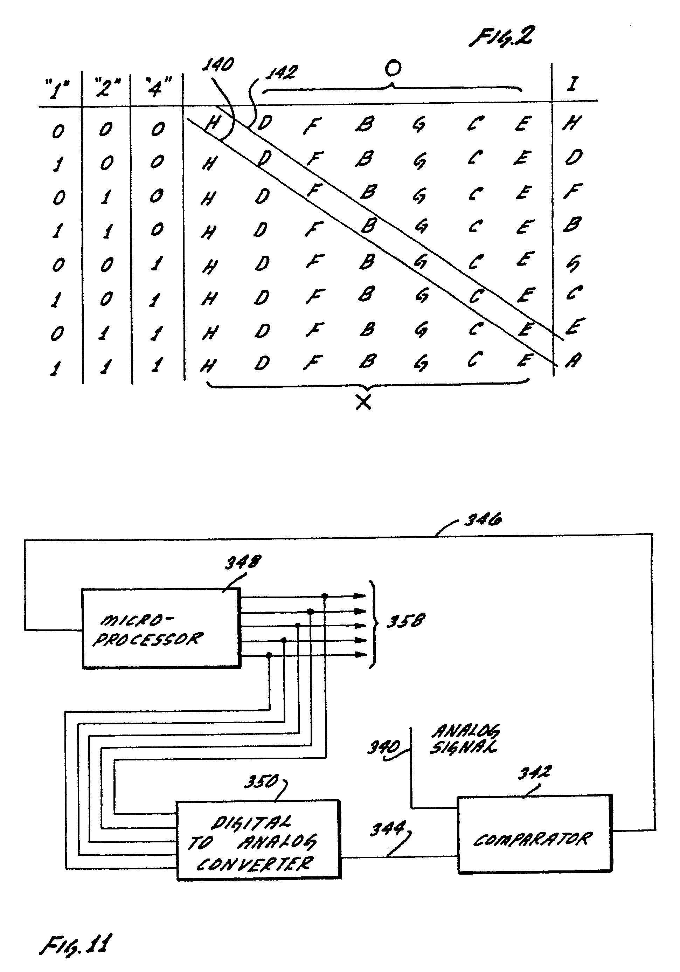

Figure 2 provides a table indicating the states of operation of the different digital values represented by the signals on the lines 12, 14 and 15. As will be seen, the first three columns of Figure 2 respectively represent the binary values of the signals on the lines 12, 14 and 15. These binary values correspond in successive rows to analog values between "0" and "7". For example, in the third row a value of "010" indicates an analog value of "2" and, in the sixth row, a digital representation of "101" represents an analog value of "5". The next seven (7) columns represent the states of connection of the capacitors. These states of conductivity are represented by the letters "A" through "H". The letters "A" through "H" in Figure 2 respectively correspond to the capacitors 110, 106, 102, 98, 94, 90, 86 and 82 in Figure 1. The letters "A" through "H" are respectively disposed adjacent these capacitors in Figure 1.

Diagonal lines 140 and 142 are shown in Figure 2. These diagonal lines delineate the capacitors connected to the output line 51 for the different values between "0" and "7" and the capacitors connected to the output line 53 for such values. The indications to the left of the diagonal line 140 represent the capacitors connected to the output line 51 and the indications to the right of the diagonal line 142 represent the capacitors connected to the output line 53. The capacitors between the lines 140 and 142 are connected to the interpolation line 55.

The number of capacitors to the left of the line 140 for any digital value corresponds to the digital value indicated in the first three columns. For example, for a digital value of "010" corresponding to an analog value of "2", the capacitors "H" and "D" are connected to the output line 51 so that the output line indicates an analog value of "2". Similarly, for a digital value of "101" corresponding to an analog value of "5", the capacitors "H", "D", "F", "B" and "G" are connected to the output line 51 so that the line 51 indicates the analog value of "5".

As will be further seen, the capacitors previously connected to the output line 51 for any digital value continue to remain connected to the output line 51 as the digital value increases. In this way, the output indication of the digital value is monotonic for any value of the count. Furthermore, by maintaining the characteristics of the different capacitors 82, 86, 90, 94, 98, 102, 106 and 110 substantially constant, the circuit shown in Figure 1 has low differential and integral non-linearities. Similarly, the capacitors previously connected to the output line 51 for a value remain connected to the output line as the value decreases. .

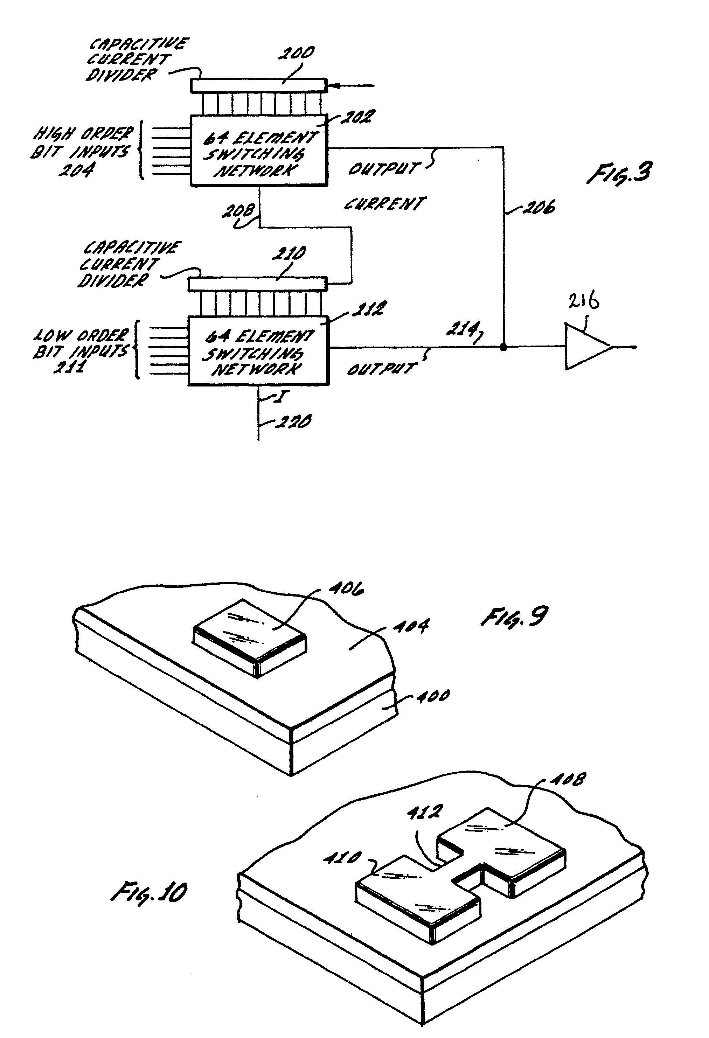

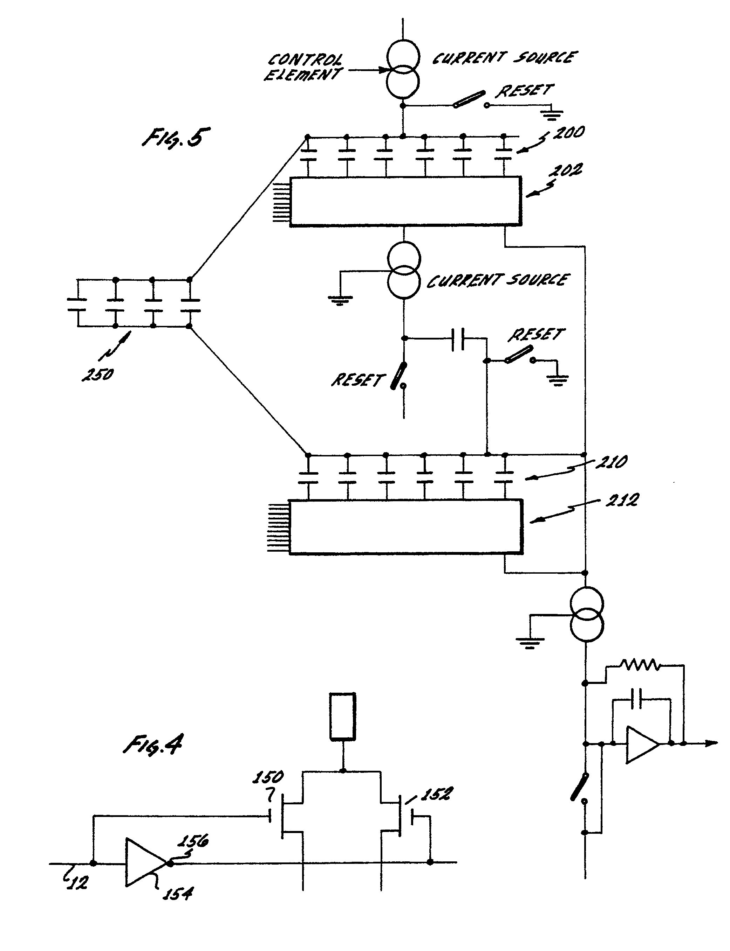

Figure 4 indicates an arrangement in which only one particular type of control transistor is used in circuitry corresponding to Figure 1 rather than the two different types of transistors actually shown in Figure 1. In the embodiment shown in Figure 4, each pair of transistors such as the transistors 16 and 18 or the transistors 20 and 22 may be provided by N-channel field effect transistors such as transistors 150 and 152. The base of the transistor 150 is directly connected to an input line such as the line 12. The input line 12 is also connected to the input terminal of an amplifier 154 having its output terminal connected to an inverter 156. A connection is made from the output of the inverter 156 to the base of the transistor 152. The amplifier 154 and the inverter 156 may be an amplifier-inverter and may be disposed in a single package.

In the arrangement shown in Figure 4, the transistor 150 becomes conductive in a manner similar to that described above for the transistor 16 when a signal representing a digital value of "1" is provided on the line 12. At such a time, the transistor 152 remains non-conductive because the digital value or "1" on the line 12 is inverted by the amplifier 154 and the inverter 156 to a digital value of "0". When a digital value or "0" is produced on the line 12, the transistor 150 becomes non-conductive in a manner similar to that described above for the transistor 16 in Figure 1. At the same time, the digital value of "0" is inverted by the amplifier 154 and the inverter 156 so that a signal representing a digital value of "1" is introduced to the base of the transistor 152 to cause the transistor to become conductive.

The converter shown in Figures 1 has certain important advantages, particularly when the converter is formed on an integrated circuit chip. One advantage is that a converter responsive to as many as sixteen (16) bits can be easily formed on an integrated circuit chip as small as 2.5 mm square. This results in part from the fact that the capacitors 82, 86, 90, 94, 98, 102, 106 and 110 can be small. Furthermore, even though the capacitors are small, they are able to be formed with variations in value of only one tenth of one percent (0.1%). This error is so small that it cannot affect the response of each capacitor to the signals representing the binary input values of "0" and "1". This insures that proper representations are provided in the converter even for the bits of least digital significance.

Figure 3 provides an arrangement for converting a considerable number of bits of digital information to a corresponding analog signal in a relatively simple manner. In the embodiment shown in Figure 3, capacitors corresponding to the capacitors 82, 86, 90, 94, 98, 102, 106 and 110 in Figure 1 are illustrated on a block basis at 200. The output members are connected in Figure 3 to a block 202 corresponding to the matrix arrangement shown in Figure 1. This block may receive signals representing the binary digits of greatest significance. By way of illustration, these signals are introduced to input lines indicated at 204 in Figure 3. Six (6) input lines are illustrated in Figure 3. These input lines correspond to lines such as the input lines 12, 14 and 15 in Figure 1.

An output line 206 extends from the matrix arrangement 202 in Figure 3. The output line 206 corresponds to the output line 51 in Figure 1. An interpolation line 208 also extends from the matrix arrangement 202 in Figure 3. The interpolation line 208 corresponds to the line 55 in Figure 1. The interpolation line 208 in Figure 3 is connected to a block 210 corresponding to the block 200 in Figure 3. The block 210 includes a plurality of capacitors such as are provided for the block 200. The capacitors are in turn connected to a matrix arrangement 212 Corresponding to the matrix arrangement 202 in Figure 3. The matrix arrangement 212 receives signals of decreased digital significance on lines 211 relative to the signals introduced on the lines 204.

An output line 214 extends from the matrix arrangement 212. The output line 214 corresponds to the output line 206 from the matrix arrangement 202. The output lines 206 and 214 may be connected to an amplifier 216.

The output voltage from the amplifier 216 indicates the analog value of the digital signals introduced through the lines 204 to the matrix arrangement 202 and the corresponding digital signals introduced to the matrix arrangement 212 through the lines 211. As will be appreciated, an amplifier such as the amplifier 216 does not have to be used in the embodiment shown in Figure 3.

An interpolation line 220 may extend from the matrix arrangement 212. The interpolation line 220 may correspond to the interpolation line 208 extending from the matrix arrangement 202. The interpolation line 220 may be connected to additional blocks (not shown) corresponding to the blocks 200 and 210. In this way, the chain arrangement shown in Figure 3 may be extended through any number of successive sequences that the user may desire. As will be appreciated, each extension of the chain increases the accuracy in which the digital information is converted to an analog voltage.

The embodiment including the blocks 200 and 202 in Figure 3 operates in a manner similar to that described above for the embodiment shown in Figure 1. In addition, a capacitive-discharge current is provided on the interpolation line 208 in a manner similar to the provision of the capacitive-discharge current on the interpolation line 54 in Figure 1. The value of this capacitive-discharge current is proportional to the number of the capacitors in the block 200 in Figure 3. For example, when the blocks 200 and 202 are responsive to signals on three input lines such as the lines 12, 14 and 15 in Figure 1, one eighth (1/8) of the capacitive-discharge current flowing from the voltage source through the block 200 is introduced to the interpolation line 208 in Figure 3. This capacitive-discharge current is then divided among the capacitors in the block 210 in a manner similar to the division of the capacitive-discharge currents in the capacitors in the block 200.

In this way, the embodiment shown in Figure 3 is able to operate to provide a conversion of a large number of digits while being constructed in a relatively simple manner. This results from the fact that the two (2) matrix arrangements for the conversion as in Figure 3 of six (6) binary bits in a 3x3 relationship is considerably more simple than a single matrix relationship for the conversion of the six (6) binary bits.

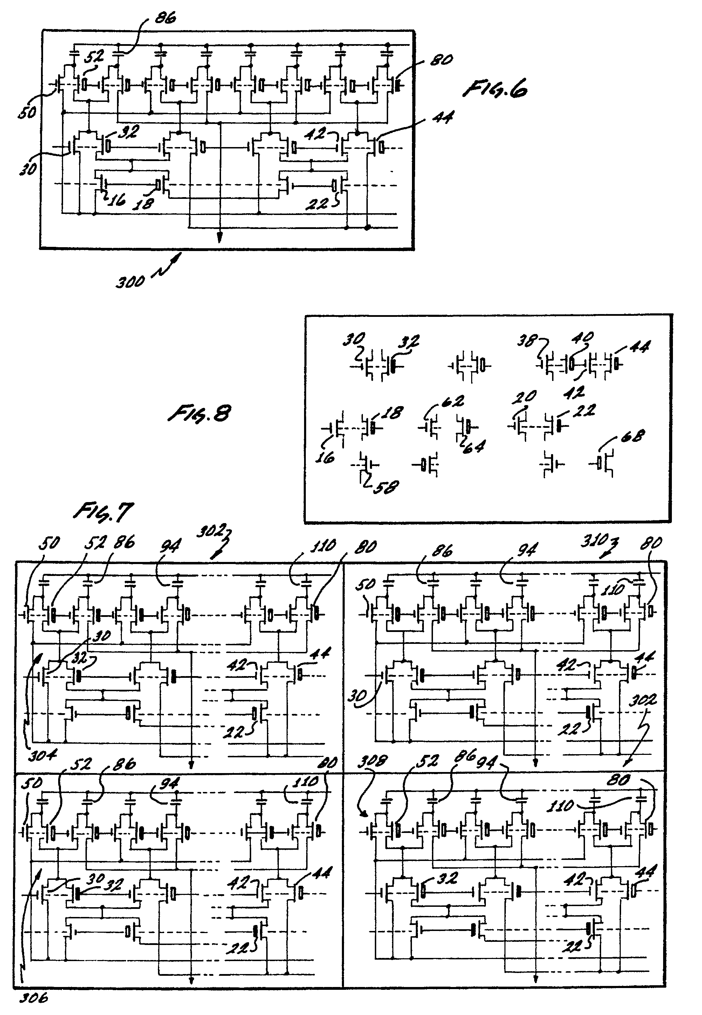

Figure 5 illustrates a modification of the system shown in Figure 3. In the embodiment shown in Figure 5, capacitors generally indicated at 250 are connected between the blocks 200 and 210 to compensate for leakage current in the matrix relationship 202. This compensation results from the fact that current flows from the current source 114 through the capacitors 250 to the block 210 to replenish in the block 210 the current lost in the block 202 as a result of leakage through stray capacitances in the block 202.

The use of capacitors in the embodiments shown in Figures 1, 3, 4 and 5 and described above offers certain important advantages, particularly when these embodiments are formed on integrated circuit chips. When capacitors are formed as the output members on the chips, they may have maximum deviations from desired values as low as one tenth of one percent (0.1%). This is true even though the capacitors may be formed at different positions throughout the chip. Because of these low deviations from a desired value, the converter of this invention is monotonic, even for the digit of least digital significance. The converter of this invention also has minimal differential and integral non-linearities.

The use of capacitors as the output members in the embodiments shown in Figures 1, 3, 4 and 5 and described above also offers other important advantages. For example, the capacitors offer minimal deviations from a temperature standpoint since all of the capacitors tend to be affected in the same manner by changes in temperature. The capacitors also tend to have minimal dissipations of energy by the flow of current through the capacitors. This is particularly true since the flow of current through the capacitors can be quite small. As a result, the converter tends to be quite stable when capacitors are used as the output members.

Futhermore, although capacitors tend to respond more slowly than other output members such as transistors, this is not of prime importance when the capacitors are used as the output members in converters for converting digital audio signals to corresponding analog signals. This results from the fact that the sampling rate for the digital audio signals is at a relatively slow rate such as approximately forty-four kiloherz (44 KHz). At this sampling rate, the capacitors can be easily charged and discharged in each timing interval, as shown in Figure 3 and described above.

The converters shown in Figures 1, 3, 4 and 5 and described above have other advantages in addition to those described above. For example, the matrix arrangement is constructed to receive directly the digital signals on the input lines such as the lines 12, 14 and 15 and to operate on such signals to provide, on the output line such as the output line 51, a current having an amplitude directly related to the analog value represented by the digital signals. In this way, the converter has a simple and straightforward construction and is still able to provide an accurate analog indication of a digital value.

By providing an arrangement in which all of the output members are capacitive and by switching progressive capacitors to an output line such as the line 51 in Figure 1 as the digital value progressively increases, the monotonic operation of tee converters shown in Figures 1, 3, 4 and 5 is assured. Furthermore, when the capacitors are made with precision and when a considerable number of capacitors are responsive to the operation of the matrix arrangements shown in Figure 1, the converters operate to provide minimal differential and integral non-linearities. The monotonic operation of the converters is further assured because all of the capacitors remain continuously charged until they are connected to either one of the output lines such as the lines 51 and 52 in Figure 1 when the switch 132 in Figure 1 becomes conductive.

Since the capacitors previously connected to the output line such as the line 51 continue to remain connected to this line for successive switching intervals represented by sequential closings of the switch 132 in Figure 1 and additional capacitors become connected to the output line 51 as the digital value progressively increases, no discontinuities are produced as the number being converted changes from a decimal value such as "511" to a decimal value such as "512" or from a decimal value such as "1023" to a decimal value such as "1024". This further assures that the converters of Figures 1, 3, 4 and 5 are monotonic.

The converters shown in Figures 1, 3, 4 and 5 described above may be incorporated on an integrated circuit chip generally indicated at 300 in Figure 6. This is particularly true in view of the simple and straightforward construction of the particular matrix arrangement such as the matrix arrangement 202 in Figure 3.

Such incorporation of the converter on the chip may be provided by large-scale integration (LSI) or very large scale integration (VLSI) techniques. In this way, the apparatus may be self-contained. Furthermore, since all of the transistors and capacitors are formed simultaneously and the chip is quite small, the transistors and capacitors respectively have substantially identical characteristics. This is particularly true since the chip has a surface area less than approximately 2.5 mm square. The simultaneous formation of the output devices on such a small chip tends to assure that the current on the output line, such as the output line 51 in Figure 1, indicates accurately in analog form the digital information represented by the signals on the input lines such as the lines 12, 14 and 15 in Figure 1.

Actually, a plurality of modules may be provided on a single chip generally indicated at 302 in Figure 7. The modules are indicated schematically at 304, 306, 308 and 310 in Figure 7. Each of the modules may be constructed in a manner similar to that shown in Figure 1. In this way, an increased number of digits can be provided by combining the modules 304 and 306 to provide a single output from the two modules. For example, the interpolation line from the module 304 may be connected to the module 306 so that the module 304 corresponds to the current divider 200 and the switching network 202 in Figure 3 and the module 306 corresponds to the current divider 210 and the switching network 212 in Figure 3. Similar connections may be made to the modules 308 and 310 to increase the number of digits being converted to an analog value.

The provision of a plurality of modules on a single chip also offers other advantages. For example, if tests indicate that the module 308 is defective, the modules 304, 306 and 310 can still be used in combination to provide an enhanced digital significance. This module can be sold to a customer who is interested only in an accuracy represented by three (3) modules rather than four (4). In this way, a defective module does not necessarily mean a destruction of the chip but indicates only that the chip may have to be downgraded in the accuracy of its conversion of digital information to analog information.

In order to increase the accuracy of the output current on the output line 51, the different transistors may be disposed in a spaced relationship such as shown in Figure 8. For example, the transistors 16, 18, 20 and 22 in Figure 1 may be considered to indicate the analog value of the binary signal on the input line 12. These transistors may be accordingly disposed at spaced positions on the chip. Similarly the transistors 30 through 44 (even numbers only) may be considered to indicate in analog form the value of the signal on the line 14. These transistors may accordingly be disposed in spaced relationship on the chip relative to each other and to the transistors 16, 18, 20 and 22.

By disposing in a spaced relationship the transistors representing each binary digit, any deviations in the characteristics of the chip at isolated positions on the chip can be averaged in the transistors of each group so that the accuracy of the output current on the line 51 is enhanced. It will be appreciated that the arrangement shown in Figure 8 is only by way of example and that the disposition of the transistors may be provided in any suitably spaced relationship to obtain the desired averaging effect.

The converters shown in Figures 1, 3, 4 and 5 described above convert digital signals to an analog representation. These converters may also be used in a system such as shown in Figure 11 to provide a conversation of analog information to a plurality of digital signals representing the analog information.

In the embodiment shown in Figure 11, an analog signal is provided on a line 340. This analog signal is to be converted to digital form. This analog signal is compared in a comparator 342 with the analog signal on a line 344 which corresponds to the output line 51 in the converter shown in Figure 1. The results of the comparison from the comparator 342 are introduced through a line 346 to a data processor such as a microprocessor 348. The microprocessor 348 processes the information represented by the signal on the line 346 and introduces signals to the input terminals of a digital-to-analog converter 350 corresponding to the converter shown in Figure 1. The signals introduced to the digital-to-analog converter 350 cause the converter to provide an analog signal on the line 344 corresponding in characteristics to the analog signal on the line 340. When the analog signal on the line 344 corresponds in characteristics to the analog signal on the line 340, the output signals on lines 358 from the microprocessor constitute the digital signals which are introduced to the analog converter of Figures 1, 3 or 4 to obtain a conversion into a corresponding analog signal.

The capacitors such as the capacitors 82, 86, 90, 94, 98, 102, 106 and 110 in Figure 1 may be formed as shown in Figure 9. In the embodiment shown in Figure 9, a first conductive sheet 400 is formed to provide a reference plane. This reference plane may be considered as the capacitor plate which is connected to the voltage source 114 in Figure 1. The second plate of each capacitor may be formed in a conventional manner on a surface 400 in which all of the transistors are also formed. This second capacitor plate for each of the capacitors is schematically illustrated at 404 in Figure 1.

It may sometimes be desired to provide capacitors of different values. This may be accomplished as shown in Figure 10. In the embodiment shown in Figure 9, a capacitance of a first value may be formed by providing on the surface 402 an area such as shown at 406. If it is desired to double the value of the capacitance, two areas 408 and 410, each of an area corresponding to the area 406, are provided as shown in Figure 10. These areas are bridged as at 412. In this way, the value of individual ones of the capacitors can be varied on the integrated circuit chip during the design and layout of the chip.

The apparatus described above has certain important advantages in addition to the advantages described above. It provides a conversion between digital and analog values at a relatively fast rate, even with the use of capacitors as the output members, because the conversion results from the connection to an output line of capacitors each constituting a simple current source. The conversion is also accurate because the control of the output signal is obtained by the operation of a plurality of control switches which are connected in a particular matrix arrangement to be instantaneously responsive to the digital signals introduced to the matrix arrangement. The conversion is accurate and reliable, particularly when the converter is disposed on an integrated circuit chip. This results from the fact that the chip is quite small and the chip has substantially uniform characteristics throughout its surface area. For example, the chip may have a surface area less than 2.5 mm square to provide an accurate conversion of sixteen (16) bits. Furthermore, the accuracy of the conversion can be enhanced by disposing the control switches in each group in a spaced relationship throughout the surface area of the chip.

The converter of this invention also has other advantages of some importance. For example, the converter is monotonic. This results from the fact that the conversion to analog form of digital signals of progressively increasing value is obtained by connecting an increased number of output members such as capacitors to a particular output line, while maintaining the connection to the particular output line of capacitors previously connected to the line. Furthermore, by connecting output members such as capacitors to the particular output line to convert digital information to an analog form, errors resulting from differential and integral non-linearities are minimized. This is particularly true when the output members are precision capacitors and when there are a considerable number of capacitors in the converters.

The converters of this invention also have other advantages of some importance. For example, they introduce digital signals directly to a particular matrix arrangement without requiring that the digital signals be modified by decoders as in the prior art. Furthermore, the matrix arrangement is relatively simple and straightforward and operates to introduce current to an output line with a magnitude directly related to the analog value represented by the digital signals. The particular matrix arrangement is further advantageous because the paired relationship of the switches in the matrix arrangement causes substantially the same number of switches in the matrix relationship to be closed regardless of the digital value to be converted. Since substantially the same number of switches remains closed, the matrix arrangement has a balanced operation which contributes to the monoticity and integral and differential linearity of the converters of this invention. The balanced operation is enhanced because all of the output members are continuously conductive during the closure of the switch 132 in Figure 1, whether they are connected to either one of the output lines such as the line 51 or the line 53 in Figure 1.

There are other important advantages to the converter of this invention. For example, the converter of this invention is quite small. This is particularly true when the converters of this invention are compared with converters which attempt to provide a comparable accuracy and reliability in the prior art. The converters of this invention are also quite inexpensive. This results in part from the production of the converter on a single chip.

The converter of this invention also offers the advantage of providing controllable output currents. This results from the fact that the amount of power delivered at the output line, such as the line 51 in Figure 1, can be adjusted by varying the number and size of the control switches in each stage in the matrix relationship. For example, the output current can be doubled by doubling the number of switches in each stage and the size of the capacitors controlling the output members. As a result of its ability to supply a controllable current, the converter of this invention can be considered to provide a current amplification at the same time that it provides a conversion. This is important in such applications as the conversion of aural information such as sound. The invention accordingly has a particular utility in the recently developed techniques of digital recording and reproduction of sound.

The apparatus of this invention is easily adaptable to provide for an addition of digits to increase it accuracy. This results in part from the modular construction of the apparatus such as shown in Figure 3 and the repetitive nature of the matrix arrangement. This is particularly true when the apparatus is disposed on a chip such as shown in Figure 6 or Figure 7. The apparatus maintains its accuracy as it ages because the chip is essentially homogeneous in construction. As a result, all of the switches and capacitors on the chip age in substantially identical relationships. The disposition of the different switches in spaced relationship on the chip also facilitates an aging in which the accuracy is maintained.

The converter is also substantially free of the effects of temperature for substantially the same reasons as discussed above with respect to aging. This is particularly true when the output members constitute capacitors. Such avoidance in the chip of the effects of temperature variations also results from the fact that the distribution of the switches in each group throughout the surface area of the chip prevents the temperature of the chip from becoming excessive at any localized areas.

The converter of this invention also has another advantage of some significance. In the particular matrix relationship shown in Figure 1, the width of the switches for each digit can be varied inversely to its numerical significance. For example, the switches 24 and 26 in Figure 1 can be made wider than the switches 30, 32, 34 and 36. This increases the accuracy in the conversion between digital and analog values.

## Claims

1. An integrated circuit digital-to-analog converter comprising a tree of switches (16, 18...30, 32...50, 52...) arranged in a succession of digital levels with the state of operation of the switches at each digital level controlled by a digital signal on a corresponding input line (12, 14, 15), a current source (114) connected to the switches (50, 52...) and connections between the switches and an output line (51) such that an output current is provided in the output line in accordance with the state of operation of the switches and of a magnitude corresponding to the value represented by the combination of digital signals applied to the input lines, and wherein the current source comprises capacitors (82, 86...) connected to the switches (50, 52...) in an extreme digital level to provide a connection of particular ones of the capacitors to the output line in accordance with the control provided on the state of operation of the switches by the digital signals, and means (132) operable to effect a change in the state of charge of the capacitors after the connection of the particular ones of the capacitors to the output line.

2. A converter according to claim 1, characterised in that first plates of the capacitors (82, 86...) are connected in common to a source (114) of charging current and to a discharging switch (132) forming the said means operable to effect the change in the state of the charge of the capacitors, and second plates of the capacitors are connected to the switches (50, 52...) in the extreme digital level.

3. A converter according to claim 1 or 2, characterised by means for periodically operating the discharging means (132) after the connection of the particular ones of the capacitors to the output line to effect periodic conversions.

4. A converter according to claim 1, 2 or 3, characterised in that the switches (16, 18...30, 32...50, 52...) and connections are such that the number of capacitors (82, 86...) contributing current to the output line (51) is proportional to the digital value represented by the signals on the input lines.

5. A converter according to any of claims 1 to 4, characterised in that the digital signals are binary and the switches are binary and the switches are arranged in pairs (e.g. 16, 18) and only one of the switches in each pair is conductive at each instant and the other switch in each pair is non-conductive at that instant and one of the switches in each pair becomes conductive then the binary signal introduced to such switches has a first binary value and the other switch in each pair becomes conductive when the binary signal introduced to such switches has a second binary value.

6. A converter according to claim 5, characterised in that the number of pairs of switches in each level increases from level to level in accordance with the digital significance of the switches in that level, the switches of each pair (e.g. 16, 18), except the highest level switches, are connected to one switch (32, 34) of each of two next higher level switch pairs, the switches (e.g. 50, 52) of each higher level switch pair are connected to a corresponding one (82) of the capacitors, and the output line (51) is connected to selected switches (e.g. 16, 30, 50) in each level which are not connected to lower level switches.

7. A converter according to any of claims 1 to 6, characterised in that a complementary output line (53) is connected to other selected switches (e.g. 22, 44) which are not connected to the first output line.

8. A converter according to claim 6 or 7, characterised in that an interpolation output line (55) is connected to a particular one of the switches, this particular switch not being connected to the output line (51) or the complementary output line (53), the particular switch being dependent upon the digital value represented by the digital input signals.

9. A converter according to claim 8, characterised in that the particular switch is connected to the output line (51) for an increase in the digital value represented by the digital input signals and is connected to the complementary output line (53) for a decrease in the digital value represented by the digital input signals.

10. A converter according to claim 8 or claim 9, characterised in that at least a pair of converters are provided each having an interpolation line and converters are cascaded with the interpolation output line (208) of the higher significance converter (200,202) providing charging current to the capacitors of a next lower significance converter (210,212).

11. A converter according to claim 10, characterised by leakage compensation cacitors (25) connected between the capacitors (200,210) of the cascaded converters.

12. A converter according to any of claims 7 to 11, characterised in that the capacitors (82, 86...) are progressively added to those contributing current to the output line (51) as the digital value represented by the signals on the input lines (12, 14, 15) progressively increasing values contributes current to the interpolating output line (55) and the remaining capacitors contribute current to the complementary output line (53).

13. An integrated circuit digital-to-analog converter according to any of claims 1 to 12, wherein the means operable to change the state of charge of the capacitors provides an abrupt change in such state of charge.

14. An integrated circuit digital-to-analog converter according to any of claims 1 to 13, wherein the capacitors (82,86...) are connected to the switches (50, 52...) in the highest digital level.

## Revendications

1. Un convertisseur numérique-analogique en circuit intégré comprenant un arbre d'éléments de commutation (16, 18 ... 30, 32 ... 50, 52 ...) disposés en une succession de niveaux numériques, avec l'état de fonctionnement des éléments de commutation à chaque niveau numérique commandé par un signal numérique sur une ligne d'entrée correspondante (12, 14, 15), une source de courant (114) connectée aux éléments de commutation (50, 52 ...) et des connexions entre les éléments de commutation et une ligne de sortie (51), de façon qu'un courant de sortie soit appliqué à la ligne de sortie conformément à l'état de fonctionnement des éléments de commutation, avec une intensité de ce courant de sortie correspondant à la valeur qui est représentée par la combinaison des signaux numériques appliqués aux lignes d'entrée, et dans lequel la source de courant comprend des condensateurs (82, 86 ...) connectés aux éléments de commutation (50, 52 ...) dans un niveau numérique extrême de façon à établir une connexion entre des condensateurs particuliers et la ligne de sortie conformément à la commande que les signaux numériques exercent sur l'état de fonctionnement des éléments de commutation, et des moyens (132) qu'on peut actionner pour changer l'état de charge des condensateurs après la connexion des condensateurs particuliers à la ligne de sortie.

2. Un convertisseur selon la revendication 1, caractérisé en ce que des premières armatures des condensateurs (82, 86 ...) sont connectées en commun a une source (114) de courant de charge et à un élément de commutation de décharge (132), constituant les moyens que l'on peut actionner pour changer l'état de charge des condensateurs, et des secondes armatures des condensateurs sont connectées aux éléments de commutation (50, 52 ...) dans le niveau numérique extrême.

3. Un convertisseur selon la revendication 1 ou 2, caractérisé par des moyens pour actionner périodiquement les moyens de décharge (132), après la connexion des condensateurs particuliers à la ligne de sortie, pour effectuer des conversions périodiques.

4. Un convertisseur selon la revendication 1, 2 ou 3, caractérisé en ce les éléments de commutation et les connexions sont tels que le nombre de condensateurs (82, 86 ...) qui fournissent du courant à la ligne de sortie (51) soit proportionnel à la valeur numérique que représentent les signaux numériques présents sur les lignes d'entrée.

5. Un convertisseur selon l'une quelconque des revendications 1 à 4, caractérisé en ce que les signaux numériques sont binaires, les éléments de commutation sont binaires, les éléments de commutation sont associés par paires (par exemple 16, 18) et un seul des éléments de commutation dans chaque paire est conducteur à chaque instant, tandis que l'autre élément de commutation dans chaque paire est bloqué à cet instant, et l'un des éléments de commutation dans chaque paire devient conducteur lorsque le signal binaire qui est appliqué à ces éléments de commutation a une première valeur binaire, tandis que l'autre élément de commutation dans chaque paire devient conducteur lors que le signal binaire qui est appliqué à ces éléments de commutation a une seconde valeur binaire.

6. Un convertisseur selon la revendication 5, caractérisé en ce que le nombre de paires d'éléments de commutation dans chaque niveau augmente de niveau en niveau conformément au poids numérique des éléments de commutation dans ce niveau, les éléments de commutation de chaque paire (par exemple 16, 18), à l'exception des éléments de commutation du niveau le plus élevé, sont connectés à un élément de commutation (32, 34) de chaque paire parmi deux paires d'éléments de commutation de niveau immédiatement supérieur, les éléments de commutation (par exemple 50, 52) de chaque paire d'éléments de commutation de niveau supérieur sont connectés à l'un correspondant (82) des condensateurs, et la ligne de sortie (51) est connectée à des éléments de commutation sélectionnés (par exemple 16, 30, 50) dans chaque niveau qui ne sont pas connectés à des éléments de commutation de niveau inférieur.

7. Un convertisseur selon l'une quelconque des revendications 1 à 6, caractérisé en ce qu'une ligne de sortie complémentaire (53) est connectée à d'autres éléments de commutation sélectionnés (par exemple 22, 44) qui ne sont pas connectés à la première ligne de sortie.

8. Un convertisseur selon la revendication 6 ou 7, caractérisé en ce qu'une ligne de sortie d'interpolation (55) est connectée à l'un particulier des éléments de commutation, cet élément de commutation particulier n'étant pas connecté à la ligne de sortie (51) ou à la ligne de sortie complémentaire (53), et l'interrupteur particulier dépendant de la valeur numérique que représentent les signaux d'entrée numériques.

9. Un convertisseur selon la revendication 8, caractérisé en ce que l'élément de commutation particulier est connecté à la ligne de sortie (51) dans le cas d'une augmentation de la valeur numérique qui est représentée par les signaux d'entrée numériques, et il est connecté à la ligne de sortie complémentaire (53) dans le cas d'une diminution de la valeur numérique qui est représentée par les signaux d'entrée numériques.

10. Un convertisseur selon la revendication 8 ou la revendication 9, caractérisé en ce qu il comprend au moins une paire de convertisseurs ayant chacun une ligne d'interpolation, et ces convertisseurs sont connectés en cascade dans une configuration dans laquelle la ligne de sortie d'interpolation (208) du convertisseur de poids supérieur (200, 202) fournit un courant de charge aux condensateurs d'un convertisseur de poids immédiatement inférieur (210, 212).

11. Un convertisseur selon la revendication 10, caractérisé par des condensateurs de compensation de fuites (25) qui sont connectés entre les condensateurs (200, 210) des convertisseurs connectés en cascade.

12. Un convertisseur selon l'une quelconque des revendications 7 à 11, caracérisé en ce que les condensateurs (82, 86 ...) sont progressivement ajoutés à ceux qui fournissent du courant à la ligne de sortie (51), au fur et à mesure de l'augmentation progressive de la valeur qui est représentée par les signaux sur les lignes d'entrée (12, 14, 15), un condensateur fournit du courant à la ligne de sortie d'interpolation (55), et les condensateurs restants fournissent du courant à la ligne de sortie complémentaire (53).

13. Un convertisseur numérique-analogique en circuit intégré selon l'une quelconque des revendica tions 1 à 12, dans lequel les moyens qu'on peut actionner pour changer l'état de charge des condensateurs produisent un changement abrupt de cet état de charge.

14. Un convertisseur numérique-analogique en circuit intégré selon l'une quelconque des revendications 1 à 13, dans lequel les condensateurs (82, 86...) sont connectés aux éléments de commutation (50, 52...) dans le niveau numérique le plus élevé.

## Ansprüche

1. Eine integrierte Digital-/Analog-Wandlerschaltung mit einem Baum von Schaltern (16, 18. .30, 32. .50, 52...), die in einer Folge von digitalen Pegeln angeordnet sind, wobei der Betriebszustand der Schalter jedes digitalen Pegels gesteuert wird durch ein Digitalsignal auf einer entsprechenden Eingangsleitung (12, 14, 15), einer mit den Schaltern (50, 52...) verbundenen Stromquelle (114) und Verbindungen zwischen den Schaltern und einer Ausgangsleitung (51) derart, daß ein Ausgangsstrom auf der Ausgangsleitung gemäß dem Betriebszustand der Schalter und einer Größe abgegeben wird, die dem Wert entspricht, der durch die Kombination von an die Eingangsleitungen angelegten Digitalsignalen dargestellt sind und wobei die Stromquelle Kondensatoren (82, 86...) aufweist, die mit den Schaltern (50, 52...) in einem extremen Digitalpegel verbunden sind, um eine Verbindung besonderer der Kondensatoren mit der Ausgangsleitung gemäß der Steuerung zu erzielen, die auf den Betriebszustand der Schalter durch die Digitalsignale ausgeübt wird, und eine Vorrichtung (132), die aktivierbar ist, um eine Änderung im Ladungszustand der Kondensatoren nach der Verbindung der besonderen der Kondensatoren mit der Ausgangsleitung zu bewirken.

2. Ein Wandler nach Anspruch 1, dadurch gekennzeichnet, daß erste Platten der Kondensatoren (82, 86...) gemeinsam mit einer Quelle (114) von Ladungsstrom und mit einem Entladungsschalter (132) verbunden sind, die die zum Bewirken der Änderung des Ladungszustandes der Kondensatoren aktivierbare Vorrichtung bilden, und daß die zweiten Platten der Kondensatoren mit den Schaltern (50, 52) in dem extremen Digitalpegel verbunden sind.

3. Ein Wandler nach Anspruch 1 oder 2, gekennzeichnet durch eine Vorrichtung zum periodischen Aktivieren der Entladungsvorrichtung (132) nach Verbinden der besonderen der Kondensatoren mit der Ausgangsleitung, um periodische Wandlungen zu bewirken.

4. Ein Wandler nach Anspruch 1, 2 oder 3, dadurch gekennzeichnet, daß die Schalter (16, 18...30, 32...50, 52...) und Verbindungen derart sind, daß die Anzahl von Kondensatoren (82, 86...), die zum Strom zu der Ausgangsleitung (51) beitragen, proportional zu dem Digitalwert ist, der durch die Signale auf den Eingangsleitungen dargestellt wird.

5. Ein Wandler nach einem der Ansprüche 1 bis 4, dadurch gekennzeichnet, daß die Digitalsignale binär sind, und die Schalter binär sind, und die Schalter in Paaren (z. B. 16, 18) angeordnet sind, und nur einer der Schalter in jedem Paar zu jedem Augenblick leitend ist, und der andere Schalter in jedem Paar in jedem Augenblick nicht-leitend ist, und einer der Schalter in jedem Paar leitend wird, wenn das solchen Schaltern eingeführte Binärsignal einen ersten Binärwert hat, und der andere Schalter in jedem Paar leitend wird, wenn das solchen Schaltern eingeführte Binärsignal einen zweiten Binärwert hat.

6. Ein Wandler nach Anspruch 5, dadurch gekennzeichnet, daß die Anzahl von Paaren von Schaltern in jedem Pegel von Pegel zu Pegel gemäß der digitalen Signifikanz der Schalter in diesem Pegel ansteigt, wobei die Schalter jedes Paares (z. B. 16, 18), ausgenommen die Schalter des höchsten Pegels, mit einem Schalter (32, 34) jedes von zwei Schalterpaaren im nächsthöheren Pegel verbunden sind, die Schalter (z. B. 50, 52) jedes Schalterpaares des höheren Pegels mit einem entsprechenden (82) der Kondensatoren verbunden sind, und die Ausgangsleitung (51) mit ausgewählten Schaltern (z. B. 16, 30, 50) in jedem Pegel verbunden ist, die nicht mit Schaltern des niedrigeren Pegels verbunden sind.

7. Ein Wandler nach einem der Ansprüche 1 bis 6, dadurch gekennzeichnet, daß eine komplementäre Ausgangsleitung (53) mit anderen ausgewählten Schaltern (z. B. 22, 44) verbunden ist, die nicht mit der ersten Ausgangsleitung verbunden sind.

8. Ein Wandler nach Anspruch 6 oder 7, dadurch gekennzeichnet, daß eine Interpolationsausgangsleitung (55) mit einem besonderen der Schalter verbunden ist, wobei der besondere Schalter nicht mit der Ausgangsleitung (51) oder der komplementären Ausgangsleitung (53) verbunden ist, und der besondere Schalter abhängig ist von dem durch die digitalen Eingangssignale dargestellten Digitalwert.

9. Ein Wandler nach Anspruch 8, dadurch gekennzeichnet, daß der besondere Schalter mit der Ausgangsleitung (51) zur Erhöhung des Digitalwertes verbunden ist, der durch die digitalen Eingangssignale dargestellt wird und verbunden ist mit der komplementären Ausgangsleitung (53) zur Verringerung des Digitalwerts, der durch die digitalen Eingangssignale dargestellt wird.

10. Ein Wandler nach Anspruch 8 oder Anspruch 9, dadurch gekennzeichnet, daß zumindest ein Paar von Wandlern vorgesehen ist, von denen jeder eine Interpolationsleitung aufweist, und daß die Wandler in Kaskade geschaltet sind mit der Interpolationsausgangsleitung (208) des Wandlers (200, 202) mit höherer Signifikanz, der einen Ladestrom an die Kondensatoren eines Wandlers (210, 212) mit nächstniedrigerer Signifikanz abgibt.

11. Ein Wandler nach Anspruch 10, gekennzeichnet durch Leckkompensationskondensatoren (25), die zwischen die Kondensatoren (200, 210) der in Kaskade geschalteten Wandler geschaltet sind.

12. Ein Wandler nach einem der Ansprüche 7 bis 11, dadurch gekennzeichnet, daß die Kondensatoren (82, 86...) progressiv zu denjenigen zugeschaltet werden, die zum Strom auf der Ausgangsleitung (51) beitragen, während der Digitalwert, der durch die Signale auf den Eingangsleitungen (12, 14, 15) dargestellt wird, progressiv ansteigende Werte zum Strom auf der Interpolationsausgangsleitung (55) beiträgt und die übrigen Kondensatoren zum Strom auf der komplementären Ausgangsleitung (53) beitragen.

13. Eine integrierte Digital-/Analog-Wandlerschaltung nach einem der Ansprüche 1 bis 12, wobei die auf eine Änderung im Ladungszustand der Kondensatoren aktivierbare Vorrichtung eine abrupte Änderung in einem solchen Ladungszustand bewirkt.

14. Eine integrierte Digital-/Analog-Wandlerschaltung nach einem der Ansprüche 1 bis 13, wobei die Kondensatoren (82, 86...) mit den Schaltern (50, 52...) in dem höchsten Digitalpegel verbunden sind.

FIG. 1

EP 0 145 335 B1

**FIG.2**

| "1" | "2" | "4" | | | | | | | | I |
|---|---|---|---|---|---|---|---|---|---|---|
| 0 | 0 | 0 | H | D | F | B | G | C | E | H |
| 1 | 0 | 0 | H | D | F | B | G | C | E | D |
| 0 | 1 | 0 | H | D | F | B | G | C | E | F |
| 1 | 1 | 0 | H | D | F | B | G | C | E | B |
| 0 | 0 | 1 | H | D | F | B | G | C | E | G |
| 1 | 0 | 1 | H | D | F | B | G | C | E | C |
| 0 | 1 | 1 | H | D | F | B | G | C | E | E |
| 1 | 1 | 1 | H | D | F | B | G | C | E | A |

140  142  O  X

**FIG.11**

MICRO-PROCESSOR  348

346

358

ANALOG SIGNAL  340

342

DIGITAL TO ANALOG CONVERTER  350

COMPARATOR

344

CAPACITIVE
CURRENT
DIVIDER

200

202

HIGH ORDER
BIT INPUTS
204

64 ELEMENT
SWITCHING
NETWORK

OUTPUT

CURRENT

FIG.3

206

208

CAPACITIVE
CURRENT
DIVIDER

210

LOW ORDER
BIT INPUTS
211

212

64 ELEMENT
SWITCHING
NETWORK

OUTPUT

214

216

I

220

406

104

FIG.9

400

408

412

410

FIG.10

Fig.5

CONTROL
ELEMENT

CURRENT SOURCE

RESET

200

202

CURRENT SOURCE

RESET

RESET

250

210

212

Fig.4

150

152

156

12

154

FIG.6

FIG.8

FIG.7